# EUROPÄISCHE PATENTSCHRIFT

(11) **EP 2 010 449 B1**
(45) Veröffentlichungstag und Bekanntmachung des Hinweises auf die Patenterteilung: **14.10.2009**
(21) Anmeldenummer: 07727176.5
(22) Anmeldetag: 21.03.2007
(51) Int. Cl.: B81B 7/00, B81C 1/00, H01L 21/768

(54) **MIKROMECHANISCHES BAUELEMENT MIT WAFERDURCHKONTAKTIERUNG SOWIE ENTSPRECHENDES HERSTELLUNGSVERFAHREN**
MICROMECHANICAL COMPONENT WITH WAFER THROUGH-PLATING AND CORRESPONDING PRODUCTION METHOD
COMPOSANT MICROMÉCANIQUE AVEC TROU MÉTALLISÉ DE PLAQUETTE ET PROCÉDÉ DE FABRICATION CORRESPONDANT

(30) Priorität: 19.04.2006 DE 102006018027
(43) Veröffentlichungstag der Anmeldung: 07.01.2009
(73) Patentinhaber: Robert Bosch GmbH, 70442 Stuttgart (DE)
(72) Erfinder: FEYH, Ando, 71732 Tamm (DE)
(86) Internationale Anmeldenummer: PCT/EP2007/052700
(87) Internationale Veröffentlichungsnummer: WO 2007/118755

(56) Entgegenhaltungen:
- EP-A- 1 489 658
- DE-A1- 10 042 945
- US-B1- 6 611 030
- PAGONIS D N ET AL: "Fabrication and testing of an integrated thermal flow sensor employing thermal isolation by a porous silicon membrane over an air cavity" JOURNAL OF MICROMECHANICS & MICROENGINEERING, INSTITUTE OF PHYSICS PUBLISHING, BRISTOL, GB, Bd. 14, Nr. 6, 1. Juni 2004 (2004-06-01), Seiten 793-797, XP020069692 ISSN: 0960-1317

## Beschreibung

### Stand der Technik

Waferdurchkontaktierungen (Vias) werden bisher mit dielektrischen Schichten elektrisch vom Substrat isoliert. Hierzu werden Vias mittels thermischer Oxidation oder LPCVD-Prozessen mit Oxiden/Nitriden beschichtet. Bei derartigen Beschichtungen sind üblicherweise hohe Temperaturen erforderlich. So werden bei der (Bulk-)Oxidation Temperaturen von typischerweise 900-1100° C erreicht. Diese hohen Temperaturen können zu einer Beschädigung von zuvor auf dem Substrat gefertigter Strukturen der Sensorelementen oder von Auswerteschaltungen in Form von ASICs führen.

Werden zur elektrischen Isolation der Waferdurchkontaktierungen Prozesse verwendet, die ohne eine derartige thermische Belastung der bereits erzeugten Strukturen bzw. Schaltungen auskommen, beispielsweise im Rahmen eines PECVD-Prozesses, kann eine konforme und tiefenhomogene Beschichtung der Vias nicht sicher gestellt werden. Eine Isolationseigenschaft bei tiefen Vias ist somit nicht gezielt erreichbar.

Die Erzeugung einer derartigen Kontaktierung ist in der Schrift DE 100 58 864 A1 aufgezeigt. In dieser Schrift wird ein Kontaktloch beschrieben, welches senkrecht in Schichten eingeätzt wird, die auf ein Substrat aufgebracht sind. Das Kontaktloch wird anschließend mit einem elektrisch leitenden Material bzw. Metall aufgefüllt und dient zur elektrischen Anbindung von vergrabenen Pads bzw. Kontaktflächen.

Eine weitere mögliche Herstellung von Kontaktlöcher wird in der DE 100 42 945 A1 beschrieben. In dieser Schrift wird ein Hohlraum mit säulenartigen Stützstrukturen innerhalb eines Bauelements erzeugt. Zur Bildung von Leitungen werden in die Stützstrukturen Kontaktlöcher geätzt, die anschließend mit Wolfram aufgefüllt werden.

Bei massiven metallischen Vias kann es aufgrund der unterschiedlichen thermischen Ausdehnungskoeffizienten zwischen dem Metall und dem das Metall direkt umgebenden Halbleitermaterial zu hohen Spannungen kommen, die einen Bruch der Vias während des Betriebs nach sich ziehen kann.

Aufgabe der Erfindung ist deshalb, unter Vermeidung eines hohen Temperatureintrags in das Substrat eine Methode zur Isolation von Waferdurchkontaktierungen bereitzustellen, die eine gute thermische und elektrische Isolationseigenschaft, gekoppelt mit einer Stressentlastung der metallischen Vias vom Substrat aufzeigen.

### Vorteile der Erfindung

Die vorliegende Erfindung beschreibt eine Waferdurchkontaktierung durch ein Halbleitersubstrat sowie ein Herstellungsverfahren für diese Waferdurchkontaktierung. Dabei wird zur Bildung der Waferdurchkontaktierung mittels eines Trenchätzprozesses wenigstens ein Via-Loch in die Vorderseite eines Halbleitersubstrats eingebracht. Anschließend wird das Halbleitermaterial der Seitenwand des Via-Lochs in einem elektrochemischen Ätzprozess porös geätzt. Zur Erzeugung der elektrischen Verbindung der Kontaktierung wird in das Via-Loch ein Metall eingebracht. Um die elektrische Verbindung von der Vorderseite zur Rückseite des Halbleitersubstrats zu ermöglichen, wird das Via-Loch von der Rückseite her geöffnet, z.B. indem das Halbleitersubstrat abgedünnt wird. Diese Öffnung kann dabei vor oder nach dem Einbringen des Metalls in das Via-Loch erfolgen.

Durch die Herstellung einer derartigen Waferdurchkontaktierung (Via) kann die elektrische Leitung, die durch die Metallisierung in dem Via-Loch erzeugt wird, sowohl vom umgebenden Halbleitersubstrat als auch von weiteren Vias elektrisch und thermisch isoliert werden. Die Verwendung einer poröse Struktur kann zudem Spannungen durch thermische Belastungen abfangen. Weiterhin kann mittels des beim Trenchätzprozess verwendeten Aspektverhältnisses eine tiefenhomogene Isolationseigenschaft über die volle Vialänge erreicht werden. Im Gegensatz zu einer Isolierung der Seitenwände mittels thermischer Oxidation oder LPCVD-Abscheidung kann so die thermische Belastung des Halbleitersubstrats niedrig gehalten werden.

Vorteilhafterweise wird die Metallisierung der Vias mittels einer Galvanik erzeugt.

Weiterhin ist vorgesehen, die poröse Schicht an der Seitenwand des Via-Lochs thermisch zu oxidieren, wobei insbesondere niedrige Temperaturen von ca. 300-400° C vorgesehen sind.

In einer Weiterbildung der Erfindung kann die Porosität der Seitenwand variiert werden, z.B. indem die Porosität ausgehend von der Seitenwand in das Substrat zunimmt. Dadurch kann die Stärke der thermischen Isolation eingestellt werden. Weiterhin ist denkbar, dass die Poren der Seitenwand eine Porengröße von unter 5 nm aufweisen.

In einer besonderen Ausgestaltung der Erfindung ist vorgesehen, dass auf die Vorderseite und/oder die Rückseite des Halbleitersubstrats ein Sensorelement aufgebracht wird. Dabei kann vorgesehen sein, dass das Sensorelement direkt in dem Halbleitersubstrat erzeugt wird oder als zusätzliches Bauelement aufgebracht wird. Die Waferdurchkontaktierung ist dabei als elektrische Anbindung des Sensorelements und als Weiterführung des elektrischen Kontakts auf die dem Sensorelement abgewandte Seite des Halbleitersubstrats vorgesehen. Alternativ oder in Ergänzung kann jedoch statt eines Sensorelements auch eine Auswerteschaltung vorgesehen sein. Die Schaltung kann dabei ebenfalls in dem Halbleitersubstrat oder in Form eines zusätzlichen Bauelements auf dem Halbleitersubstrat aufgebracht werden.

Weitere Vorteile ergeben sich aus der nachfolgenden Beschreibung von Ausführungsbeispielen bzw. aus den abhängigen Patentansprüchen.

### Zeichnungen

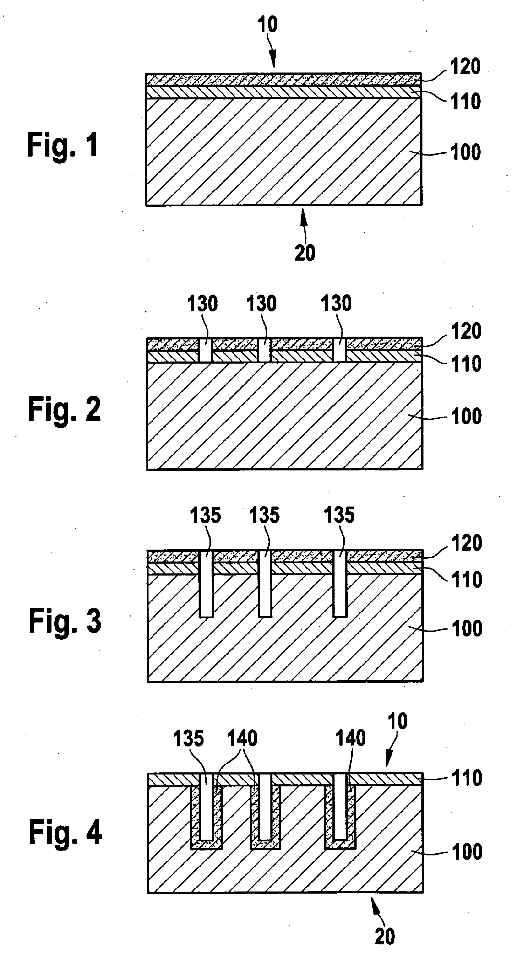

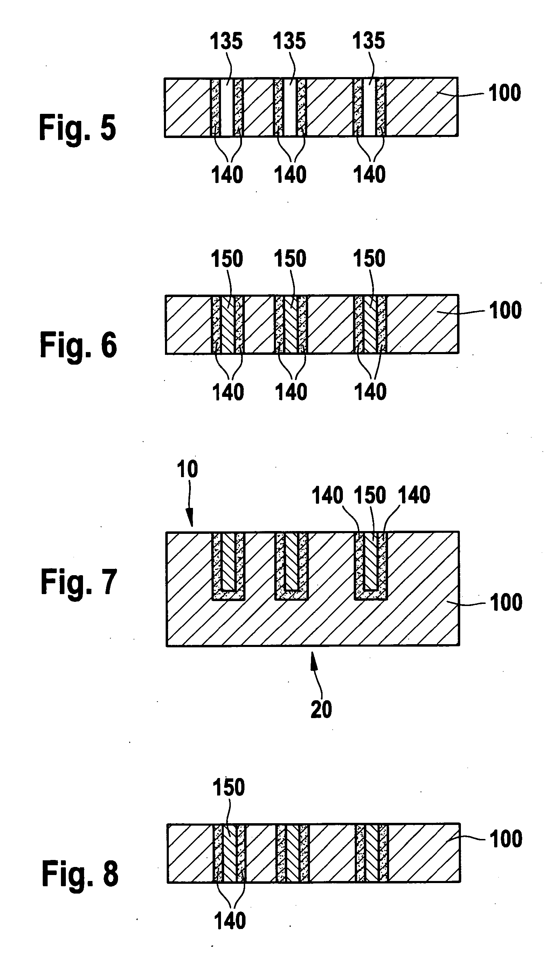

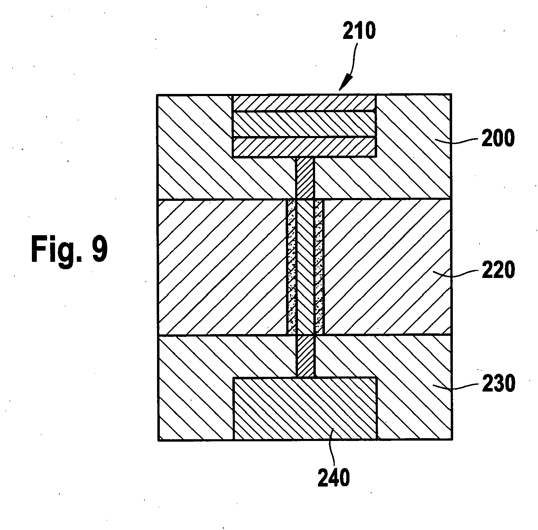

Die Figuren 1 bis 8 zeigen beispielhaft die Herstellung einer erfindungsgemäßen Waferdurchkontaktierung. Figur 9 stellt ein besonders Ausführungsbeispiel dar, welches die Verbindung eines Sensorelements und einer (Auswerte-)Schaltung mittels der Waferdurchkontaktierung zeigt.

### Ausführungsbeispiel

Wie in Figur 1 gezeigt, wird auf die Oberfläche (10) eines Siliziumsubstrat (100) zunächst eine erste Maskierschicht (110) beispielsweise aus SiN, Si₃N₄ oder einer n-dotierten Zone des Siliziumsubstrats für die Herstellung des porösen Siliziums sowie eine zweite Maskierschicht (120) aus Oxid oder Photolack für den nachfolgenden Trenchätzschritt aufgebracht. Vorzugsweise werden Siliziumwafer bei mikromechanischen Bauelementen eingesetzt wobei durchaus auch Wafer aus anderen Halbleitermaterialien Verwendung finden können.

In einem ersten Prozessschritt werden mittels einer geeigneten Strukturierung Löcher (130) in die erste und zweite Maskierschicht (110 bzw. 120) eingebracht, durch die im nachfolgenden Prozessschritt der Trenchätzschritt durchgeführt wird. Mittels dieses Trenchätzschritts werden eine oder mehrere (tiefe) Via-Löcher (135) in dem Siliziumsubstrat (100) erzeugt. Anschließend wird die zweite Maskierung (120) entfernt, wie in Figur 4 zu sehen ist. Mit einem elektrochemischen Ätzprozess wird dann das Silizium der Seitenwände der Via-Löcher porös geätzt, wobei die erste Maskierungsschicht (110) ein Ätzen der Oberfläche (10) des Siliziumsubstrats (100) verhindert. Die Ausdehnung des so erzeugten porösen Bereichs (140) im Siliziumsubstrat (100) ist dabei abhängig von den verwendeten Ätzparametern wie Säurestärke, angelegte Stromstärke und Ätzzeit. Als Ätzmedium bietet sich ein flussäurehaltiges Elektrolyt wie HF an, wobei auch andere Medien verwendet werden können, die einen porösifizierenden Effekt auf das verwendeten Halbleitermaterial haben.

Ausgehend von der Figur 4 wird zunächst an einem Ausführungsbeispiel gezeigt, dass nach Herstellung der Via-Löcher (135) mit porösen Seitenwänden (140) das Halbleitersubstrat (100) von der Rückseite (20) her abgedünnt wird (siehe Figur 5) bevor mittels einer Metallisierung, z.B. einem galvanischen Prozess, die Via-Löcher (150) befüllt werden (siehe Figur 6). Alternativ kann auch vorgesehen sein, dass die Via-Löcher (150) zuerst mit der Metallisierung befüllt werden, bevor die Via-Löcher (150) von der Rückseite (20) des Halbleitersubstrats (100) geöffnet werden (siehe Figur 7 und 8).

Durch eine geeignete Steuerung der Ätzparameter lässt sich neben der Dicke der porösifizierten Schicht auch die Porengröße einstellen. Dabei kann beispielsweise nanoporöses Silizium mit Porengrößen von unter 5 nm erzeugt werden. Weiterhin kann der Porositätsgradient während der Porosifizierung variiert werden. Denkbar sind hierbei niederporöse Schichten an der Oberfläche der Seitenwand und hochporöse Schichten zum Substrat hin. Dies hätte Haftvorteile von zusätzlich abgeschiedenen Schichten bzw. hinsichtlich der nachfolgenden Metallisierung. Gleichzeitig würde ein derartiger Porositätsgradient eine zusätzliche Erhöhung der Isolation erzeugen.

Alternativ ist auch möglich, die poröse Schicht bei geringen Temperaturen, d.h. bei 300-400° C zu oxidieren. Hierdurch kann die Isolationswirkung ebenfalls verbessert werden. Bei geeigneter Wahl der Porosität kann nach der Oxidation aufgrund des Volumenzuwachses des oxidierten porösen Siliziums eine geschlossene Oxidationsoberfläche erzeugt werden, ohne entsprechend hohe Temperaturen verwenden zu müssen, die ansonsten für eine Bulk-Oxidation notwendig sind.

Die erfindungsgemäße Waferdurchkontaktierung kann beispielsweise bei der Herstellung eines mikromechanischen Sensorelements verwendet werden. So ist denkbar, dass auf dem Siliziumsubstrat mikromechanische Strukturen für ein Sensorelement wie beispielsweise ein Beschleunigungsmesser, ein Drehratenmessor, ein Luftmassenmesser oder ein Drucksensor erzeugt werden, die mittels der Waferdurchkontaktierung elektrisch angebunden bzw. angesteuert werden. Vorteilhaft ist dabei, dass die elektrische Ansteuerung durch das Substrat hindurch auf die andere Seite des Substrats geführt werden kann. Optional kann auch vorgesehen sein, dass auf der anderen Seite des Substrats bereits Schaltungselemente vorgesehen sind, die eine Aufnahme oder Auswertung der Sensormesswerte durchführen. Der Vorteil bei derartigen Leitungsführungen besteht darin, dass auf der Oberfläche des Sensorelements weniger Platz benötigt wird, um die Messsignale abzuführen bzw. auszuwerten.

Eine weitere Anwendung der erfindungsgemäßen Waferdurchkontaktierung besteht darin, ein oder zwei separate Bauelemente, die ihrerseits bereits fertig prozessierte Sensorelemente oder Schaltungen aufweisen, miteinander mechanisch und elektrisch zu verbinden, d.h. zu kontaktieren. Als mögliches Beispiel sei dabei auf die Figur 9 verwiesen, bei der ein Sensorelement (200) über ein mit einer Waferdurchkontaktierung versehenes Bauelement (220) mit einem Auswertechip (230) verbunden ist. Dabei wird das Messsignal eines kapazitiven Drucksensors (210) mit einer oberen und einer unteren Elektrode (angeschlossen ist im Beispiel die untere Elektrode) nach unten weitergeleitet und zur Auswertung an einen mit einer entsprechenden Schaltung (240) versehenen Auswertechip (230) weitergeleitet.

## Patentansprüche

1. Verfahren zur Erzeugung wenigstens einer Waferdurchkontaktierung (150) durch ein Halbleitersubstrat (100), wobei zur Bildung der Waferdurchkontaktierung (150)
- wenigstens ein Via-Loch (135) in die Vorderseite (10) eines Halbleitersubstrats (100) mittels eines Trenchätzprozesses eingebracht wird und
- die Seitenwand (140) des wenigstens einen Via-Lochs mittels eines elektrochemischen Ätzprozesses porös geätzt wird und
- das Via-Loch (150) mittels einer Metallisierung verfüllt wird und
- das Via-Loch von der Rückseite (20) des Halbleitersubstrats geöffnet wird.

2. Verfahren nach Anspruch 1, **dadurch gekennzeichnet, dass** die Metallisierung mittels einer Galvanik erfolgt.

3. Verfahren nach einem der vorhergehenden Ansprüche, **dadurch gekennzeichnet, dass** die Metallisierung nach der Öffnung des Via-Lochs erfolgt.

4. Verfahren nach einem der vorhergehenden Ansprüche, **dadurch gekennzeichnet, dass** die Öffnung des wenigstens einen Via-Lochs von der Rückseite mittels einer Rückdünnung des Halbleitersubstrats erfolgt.

5. Verfahren nach einem der vorhergehenden Ansprüche, **dadurch gekennzeichnet, dass** die poröse Schicht (140) an der Seitenwand thermisch oxidiert wird, wobei insbesondere vorgesehen ist, dass die thermische Oxidation bei Temperaturen von 300-400° C erfolgt.

6. Verfahren nach einem der vorhergehenden Ansprüche, **dadurch gekennzeichnet, dass** die Waferdurchkontaktierung
- nach der Herstellung eines Sensorelements und/oder einer Auswerteschaltung auf der Vorderseite bzw. Rückseite des Halbleitersubstrats erzeugt wird und
- eine elektrische Verbindung mit dem Sensorelements und/oder der Auswerteschaltung aufweist.

7. Mikromechanisches Bauelement mit einem Halbleitersubstrat, welches eine insbesondere nach einem der Verfahren in den Ansprüche 1 bis 6 hergestellte Waferdurchkontaktierung aufweist,
wobei die Waferdurchkontaktierung ein durch einen Trenchätzprozess von der Vorderseite in das Halbleitersubstrat eingebrachtes Via-Loch aufweist,
wobei das Via-Loch
- eine Seitenwand aus porös geätztem Halbleitermaterial und
- eine Metallisierung und
- eine Öffnung zur Rückseite des Halbleitersubstrats
aufweist.

8. Mikromechanisches Bauelement nach Anspruch 7, **dadurch gekennzeichnet, dass** die Porösität ausgehend von der Seitenwand des Via-Lochs in das Substrat hin zunimmt.

9. Mikromechanisches Bauelement nach einem der Ansprüche 7 oder 8, **dadurch gekennzeichnet, dass** die Poren eine Porengröße von unter 5 nm aufweist.

10. Mikromechanisches Bauelement nach einem der Ansprüche 7 bis 9, **dadurch gekennzeichnet, dass** das Halbleitersubstrat auf der der Vorderseite bzw. Rückseite ein Sensorelement und/oder eine Auswerteschaltung auf des Halbleitersubstrats aufweist und die Waferdurchkontaktierung eine elektrische Verbindung mit dem Sensorelements und/oder der Auswerteschaltung aufweist.

11. Mikromechanisches Bauelement nach einem der Ansprüche 7 bis 9, **dadurch gekennzeichnet, dass** auf das Halbleitersubstrat ein Bauelement mit einem Sensorelement und/oder einer Auswerteschaltung aufgebracht wird und die Waferdurchkontaktierung im Halbleitersubstrat eine elektrische Verbindung zu dem Sensorelements und/oder der Auswerteschaltung aufweist.

## Claims

1. Method for producing at least one wafer via (150) through a semiconductor substrate (100), wherein, in order to form the wafer via (150),
- at least one via hole (135) is introduced into the front side (10) of a semiconductor substrate (100) by means of a trench etching process,
- the sidewall (140) of the at least one via hole is etched porously by means of an electrochemical etching process, and
- the via hole (150) is filled by means of a metallization, and
- the via hole is opened from the rear side (20) of the semiconductor substrate.

2. Method according to Claim 1, **characterized in that** the metallization is effected by means of electrodeposition.

3. Method according to any of the preceding claims,
**characterized in that** the metallization is effected after the via hole has been opened.

4. Method according to any of the preceding claims,
**characterized in that** the at least one via hole is opened from the rear side by means of the semiconductor substrate being thinned back.

5. Method according to any of the preceding claims,
**characterized in that** the porous layer (140) at the sidewall is thermally oxidized, wherein provision is made, in particular, for the thermal oxidation to be effected at temperatures of 300-400°C.

6. Method according to any of the preceding claims,
**characterized in that** the wafer via
- is produced after the production of a sensor element and/or of an evaluation circuit on the front side and/or rear side of the semiconductor substrate, and
- has an electrical connection to the sensor element and/or the evaluation circuit.

7. Micromechanical component comprising a semiconductor substrate, having a wafer via produced in particular according to one of the methods in Claims 1 to 6,
wherein the wafer via has a via hole introduced into the semiconductor substrate from the front side by means of a trench etching process,
wherein the via hole has
- a sidewall composed of porously etched semiconductor material and
- a metallization and
- an opening to the rear side of the semiconductor substrate.

8. Micromechanical component according to Claim 7,
**characterized in that** the porosity increases proceeding from the sidewall of the via hole into the substrate.

9. Micromechanical component according to either of Claims 7 and 8, **characterized in that** the pores have a pore size of less than 5 nm.

10. Micromechanical component according to any of Claims 7 to 9, **characterized in that** the semiconductor substrate has on the front side and/or rear side a sensor element and/or an evaluation circuit on the semiconductor substrate and the wafer via has an electrical connection to the sensor element and/or the evaluation circuit.

11. Micromechanical component according to any of Claims 7 to 9, **characterized in that** a component with a sensor element and/or an evaluation circuit is applied to the semiconductor substrate and the wafer via in the semiconductor substrate has an electrical connection to the sensor element and/or the evaluation circuit.

## Revendications

1. Procédé pour former à travers un substrat semi-conducteur (100) une perforation de contact (150) de galette, dans lequel pour former la perforation de contact (150) à travers la galette :
- au moyen d'une opération de gravure en tranchée, on ménage au moins une perforation (135) dans le côté avant (10) d'un substrat semi-conducteur (100) et
- pour rendre poreuse la paroi latérale (140) de la ou des perforations, on la grave au moyen d'une opération de gravure électrochimique,
- on remplit la perforation (150) d'une métallisation et
- on ouvre la perforation sur le côté arrière (20) du substrat semi-conducteur.

2. Procédé selon la revendication 1, **caractérisé en ce que** la métallisation est réalisée par un procédé galvanique.

3. Procédé selon l'une des revendications précédentes, **caractérisé en ce que** la métallisation est réalisée après l'ouverture de la perforation.

4. Procédé selon l'une des revendications précédentes, **caractérisée ce que** l'ouverture de la ou des perforations par le côté arrière s'effectue au moyen d'un amincissement du substrat semi-conducteur par la face arrière.

5. Procédé selon l'une des revendications précédentes, **caractérisé en ce que** la couche poreuse (140) formée sur la paroi latérale est oxydée thermiquement en prévoyant en particulier de réaliser l'oxydation thermique à une température comprise entre 300 et 400°C.

6. Procédé selon l'une des revendications précédentes, **caractérisé en ce que** la perforation de contact à travers la galette :
- est formée après l'établissement d'un élément de détection et/ou d'un circuit d'évaluation sur le côté avant ou le côté arrière du substrat semi-conducteur et
- **en ce qu'**elle présente une liaison électrique avec l'élément de détection et/ou le circuit d'évaluation.

7. Composant micromécanique doté d'un substrat semi-conducteur qui présente à travers la galette une perforation de contact réalisée en particulier selon l'un des procédés selon les revendications 1 à 6,
dans lequel la perforation de contact à travers la galette présente une perforation ménagée dans le substrat semi-conducteur depuis son côté avant par une opération de gravure en tranchée,
la perforation présentant :
- une paroi latérale constituée d'un matériau semi-conducteur rendu poreux par gravure,
- une métallisation et
- une ouverture sur le côté arrière du substrat semi-conducteur.

8. Composant micromécanique selon la revendication 7, **caractérisé en ce que** la porosité augmente entre la paroi latérale de la perforation et le substrat.

9. Composant micromécanique selon l'une des revendications 7 ou 8, **caractérisé en ce que** les pores ont une taille inférieure à 5 nm.

10. Composant micromécanique selon l'une des revendications 7 à 9, **caractérisé en ce que** le substrat semi-conducteur présente un élément de détection et/ou un circuit d'évaluation sur le côté avant ou le côté arrière du substrat semi-conducteur et **en ce que** la perforation de contact à travers la galette présente une liaison électrique avec l'élément de détection et/ou le circuit d'évaluation.

11. Composant micromécanique selon l'une des revendications 7 à 9, **caractérisé en ce qu'**un composant doté d'un élément de détection et/ou d'un circuit d'évaluation est appliqué sur le substrat semi-conducteur et **en ce que** la perforation de contact à travers la galette réalisée dans le substrat semi-conducteur présente une liaison électrique avec l'élément de détection et/ou le circuit d'évaluation.
